# EUROPEAN PATENT APPLICATION

(11) **EP 2 085 955 A1**
(43) Date of publication of application: **05.08.2009**
(21) Application number: 08001888.0
(22) Date of filing: 01.02.2008
(51) Int. Cl.: G09F 19/22, G09F 9/33

(54) **Display panel and large-area display system**

(71) Applicant: G-LEC Europe GmbH, 76470 Ötigheim (DE); Mironovs, Sergejs, Riga 1082 (LV)
(72) Inventor: Volohovs, Dmitrijs, Riga 1082 (LV); Mironovs, Sergejs, Riga 1082 (LV)
(74) Representative: Eisenführ, Speiser & Partner

(57) **Abstract**

A cuttable display panel (2), comprising: a printed circuit board (PCB) (4); a two-dimensional array of light emitting elements (5) mounted on the PCB (4); a control circuitry electrically connected to the light emitting elements (5) for controlling their light emission, **characterized in that** the panel (2) is adapted for mounting on a wall; said control circuitry comprises a plurality of light drivers (6) connected to the light emitting elements (5) on one-to-one basis; and that a part of the panel (2) can be removed, for example by cutting out, to accommodate an obstacle on the wall. A large-area display system (1) comprising a plurality of panels (2) and a method for assembling the display system (1) are further provided.

## Description

### FIELD OF THE INVENTION

This invention relates to display systems and more particularly to large-area display systems constructed of a plurality of display panels.

### BACKGROUND OF THE INVENTION

Large-area display systems are widely used for displaying pictures and information in sports fields, recreation grounds, outdoor and indoor advertisements, and also more and more in architectural installations.

Such display systems have commonly been constructed of numbers of light emitting elements, such as light emitting diodes (LEDs) mounted on flat panels. These light emitting elements may be selectively turned on and off to create patterns, graphics, and video images for both informational and aesthetic purposes. It is well known to construct such displays of panels or tiles each containing a plurality of light emitting elements. Examples of such systems are disclosed in U.S. Pat Nos. 6,314, 669 and 5,990,802.

In architectural installations there is a problem of arranging large-area display systems, especially on walls of various existent structures. The walls of the existent structures are usually provided with quite a number of prominent construction elements, such as branch tubes, beam ends, cantilevers etc. For example, sometimes a large-area display system should be installed behind a transparent glass facade of a building. In this particular case, there are a lot of glass support members protruding from the wall, and each protruding obstacle prevents mounting of one or even several panels, thus creating dark areas on the display surface.

Another disadvantage of this known design is that the systems cannot be accurately fitted into customer-defined construction sizes, because a minimum user- configurable element is a panel, the size of the display system is multiple to the panel size. For example, if it is necessary to remove just one pixel from any side of the display, the complete display panel will be removed. The prior art display systems are limited in application due to its construction features.

U.S. Pat. No. 6,784,458 to Wang et al. proposes a LED display panel, which is partitionable and configurable to different number of pixels. This is achieved by arranging the LEDs of a display as a matrix array. The metal interconnections for accessing the LEDs of the matrix array are laid out as vertical columns and horizontal rows as in a two-dimensional random access memory array. These matrix array can be cut and partitioned to reduce the number of pixels of the display panel, or be expanded to increase the number of pixels. The partitioned sub-arrays can be pieced together by aligning the corresponding interconnections and connecting them through a motherboard.

However, this prior art display panel has a serious disadvantage of using a dynamic method of driving LEDs wherein a particular LED is activated by coincident addressing. Thus, only one row or column of LEDs can be energized simultaneously. This leads to a reduced brightness of the display.

Another disadvantage of the display panel disclosed in U.S. Pat. No. 6,784,458 is an insufficient flexibility of partitioning. A particular LED of this panel is activated when appropriate row X and column Y are activated concurrently. If we cut out a single LED from the middle of row X, we will break the common metal interconnection line for the leftward LEDs in row X. If we cut out a single LED from the middle of column Y, we will break the common metal interconnection line for remaining LEDs, which are located atop the cut out LED in column X.

Further, such a configuration requires multiple wire connections from panels and partitioned sub-arrays to a motherboard. This may present problems in assembling and troubleshooting the display system.

Thus, the prior art display panel has serious disadvantages especially in architectural installations.

Due to all of the deficiencies in the prior art, an improved display panel system is needed.

### SUMMARY OF THE INVENTION

The general purpose of the present invention is to provide a customizable display panel the size and shape of which can be customized according to the application requirements.

Another object of the present invention is to provide a large-area display system which can be mounted on an existing architectural structure, for example, a wall and which can be configured to accommodate an existing obstacle on the wall.

By "wall" herein is meant any constructional surface, it can be a vertical interior or exterior wall of the building, it can be a tilted surface of the roof, it can be ceiling or a floor surface.

Still another object of this invention is to provide a method for assembling a large-area display system, predominantly in an architectural installation, which facilitates arbitrarily arranging the large-area display system on a large surface with a number of protruded elements.

According to the present invention there is provided a cuttable display panel, comprising: a printed circuit board (PCB); a two-dimensional array of light emitting elements mounted on the PCB; a control circuitry electrically connected to the light emitting elements for controlling their light emission, characterized in that the panel is adapted for mounting on a wall; said control circuitry comprises a plurality of light drivers connected to the light emitting elements on one-to-one basis; and that a part of the panel can be removed, for example by cutting out, to accommodate an obstacle on the wall.

Preferably, the light emitting element comprises a first terminal and a second terminal, wherein said first terminal is connected to a common wire; and said second terminal is connected to the corresponding light driver.

Preferably, the PCB comprises a non-cuttable region and a cuttable region, wherein said light drivers are mounted in the non-cuttable region of said PCB.

Preferably, said light emitting element comprises a light emitting diode (LED).

Preferably, said cuttable region is located in a peripheral part of said PCB, and the removable part is a marginal part.

Preferably, said cuttable region comprises a corner part, wherein a light emitting element located in said corner part is connected to said light driver at least by two printed wires.

Preferably, said two printed wires connecting said light emitting element to said light driver are located substantially along a rectangle having one corner in a vicinity of said light emitting element and the diagonally opposite corner in the non-cuttable region of said PCB.

According to another aspect of the invention there is provided a large-area display, comprising a plurality of display panels mounted on a wall, wherein each of the display panels comprises: a printed circuit board (PCB); a two-dimensional array of light emitting elements mounted on the PCB; a control circuitry electrically connected to the light emitting elements for controlling their light emission, characterized in that said control circuitry comprises a plurality of light drivers connected to the light emitting elements on one-to-one basis; said plurality of display panels comprises at least one cuttable panel a part of which is removed to accommodate an obstacle on the wall.

According to still another aspect of the invention there is provided a method for assembling a large-area display, comprising the following steps: providing a plurality of panels, adapted for mounting on a wall wherein said plurality comprises a number of cuttable panels; providing a wall allowably having an obstacle; cutting out a part of the cuttable panel to accommodate an obstacle on the wall; fixing said plurality of panels on the wall; connecting said plurality of panels to each other and/or to data and power sources.

These and other advantages and novel features of the present invention, as well as details of an illustrated embodiment thereof, will be more fully understood from the following description and drawings.

### BRIEF DESCRIPTION OF THE DRAWINGS

Fig. 1 shows an embodiment of a display system in accordance with the present invention;
Fig. 2a illustrates a front perspective view of one of display panels used to construct the display system in Fig. 1;
Fig. 2b illustrates a back perspective view of the display panel in Fig. 2a;
Fig. 3 illustrates a variety of possible cutouts of the display panel;
Fig. 4a illustrates a layout of conductive traces in the cuttable region of PCB;
Fig. 4b illustrates a PCB with two exemplary cutouts;
Fig. 5 illustrates electrical connection of a LED and a LED driver;
Fig. 6 illustrates a front perspective view and a back perspective view of an alternative embodiment of the display panel;
Fig. 7 illustrates another embodiment of the display panel;
Fig. 8 illustrates an embodiment of a display system in accordance with the present invention.

### DETAILED DESCRIPTION OF THE PREFERRED EMBODIMENTS

The invention is illustrated with reference to the following examples.

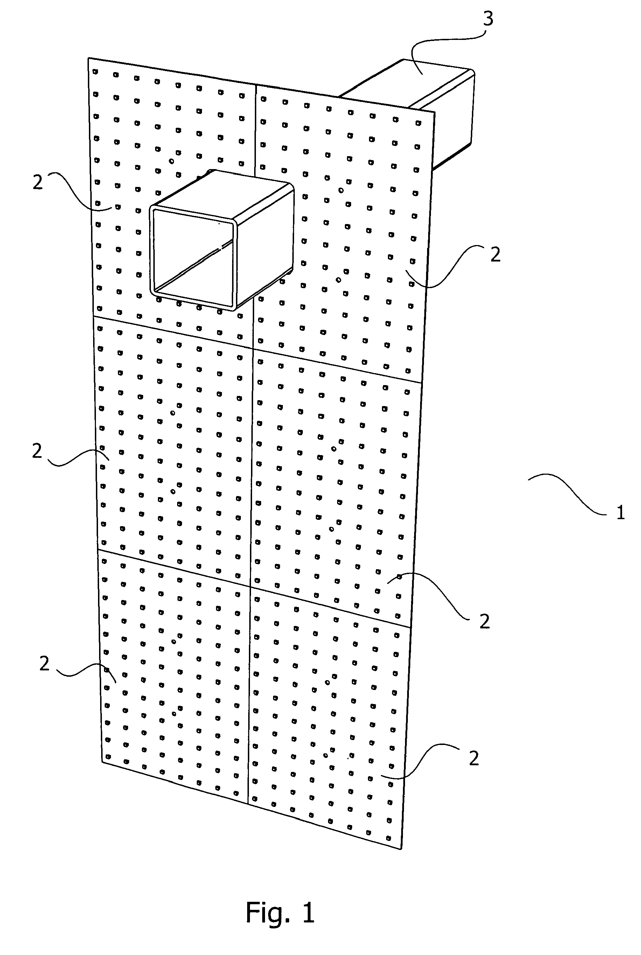

Referring to Fig. 1, a front perspective view of a display system 1 in accordance with embodiments disclosed herein is shown. The system 1 is constructed of a plurality of elementary display panels 2 mounted on a building wall (not shown), which is provided with a holder for facade glass in the form of a square tube 3. During construction of the display system 1 corresponding parts of the display panels 2 are cut out and the tube 3 passes through the display system 1. In actual application shelf holder elements, water pipes or other architectural or construction elements may protrude from the wall surface and require similar approach to construction of the display system. In the shown embodiment the display panels 2 are arranged in two columns and three rows per column. However, those skilled in the art will recognize that various other combinations of the display panels 2 may be connected to each other to provide other configurations of the overall display.

By "wall" herein is meant any constructional surface. For example the display system can be mounted on a ceiling supported with a number of columns. During construction of such a display system, corresponding parts of certain panels are cut out, providing passing over the columns.

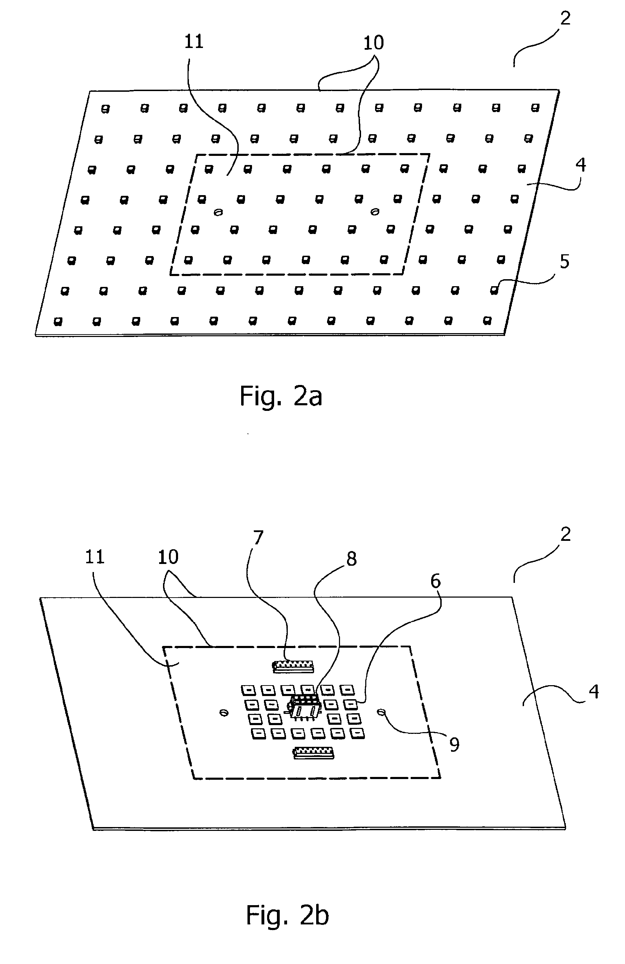

Fig. 2a illustrates a front perspective view of the display panel 2 and Fig. 2b illustrates a back perspective view of the display panel 2. As it is shown in the drawings, the panel 2 includes a PCB 4 and mounted on its front surface light emitting elements 5. In this preferred embodiment the light emitting elements 5 are mounted in 8x12 array, however any other configuration is possible. Preferably light emitting elements are light emitting diodes (LED). In the preferred embodiments are used monochrome LEDs NSSW100, manufactured by Nichia, Japan. Those skilled in the art will appreciate that any other configuration of the light emitting element is possible, for example light emitting diodes of three colors, red, green and blue may be used.

The panel 2 further comprises LED drivers 6, data connectors 7 and a power connector 8 all mounted on the back surface of the PCB 4. The PCB has also mounting holes 9 for attachment of the display panel 2 to a support construction or holding frame. Those skilled in the art will appreciate that any other mounting means may be used for fixing a display panel to a wall.

The PCB 4 is divided into two areas, a cuttable region 10 and non-cuttable region 11. The non-cuttable region 11 is located at the PCB central part. The cuttable region 10, located in a peripheral part of the PCB 4, is a physical segment, where any part of the PCB 4 can be cut out without breaking functionality of other part of the PCB, or as the PCB essentially is a panel, it is also true that a part of the panel can be cut out without breaking functionality of remaining part. Cutting out can be made, for example, by milling method, known to those skilled in the art. The cuttable region 10 surrounds the non-cuttable region 11. The LED drivers 6, data connectors 7 and power connector 8 are located within the non-cuttable region 11.

The PCB 4 is made of a monolith single piece material, preferably a non-reflective or essentially non-reflective fiberglass material, which contains a black pigment or black solder resist mask, known to those skilled in the art. It is also possible to paint the PCB surface to any other color according to architect's or designer's requirements.

The LED drivers 6 are standard DC driver, for example MBI5170, Macroblock, Taiwan.

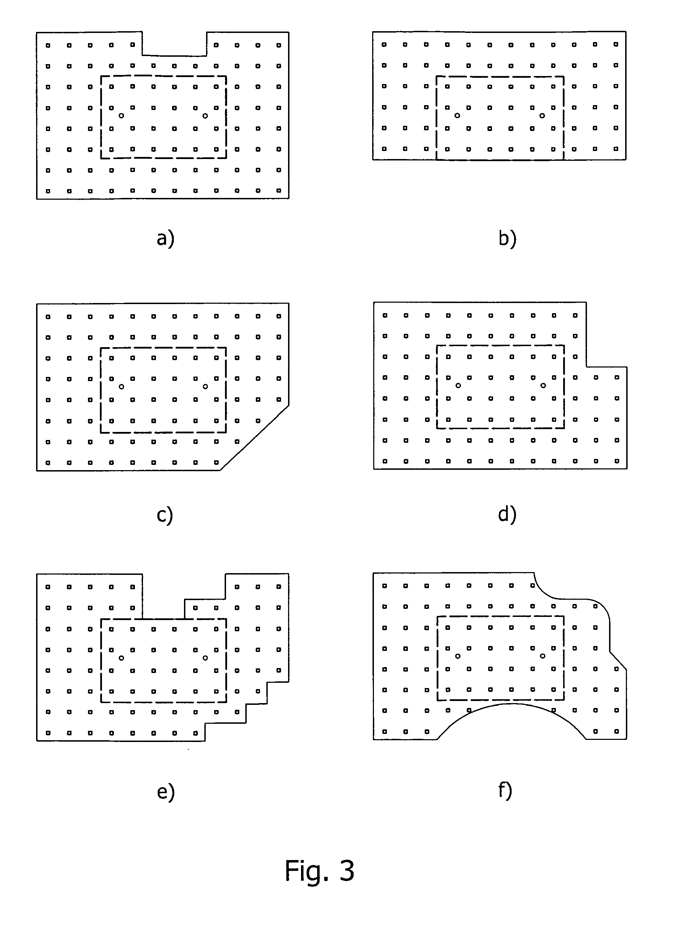

Fig.3 illustrates a variety of possible cuttings of a display panel 2 in accordance with the present invention. Version a) shows the cut out middle part of the panel top row. Entire two bottom rows may be cut out, as it is shown in view b). Cut out areas may be slantwise, angular or stepwise, as it may be seen in versions c), d) and e). The cut out area may be also curvilinear, as in version f). Any other form of a cutout is possible, provided the cutout is a marginal cutout, that is that the cutout resembles by form a cross-section of a trench without negative slops.

Thus, the offered invention provides a high degree of arbitrariness of cutting out the display panels, which is especially important in constructing large-area displays in architectural installations.

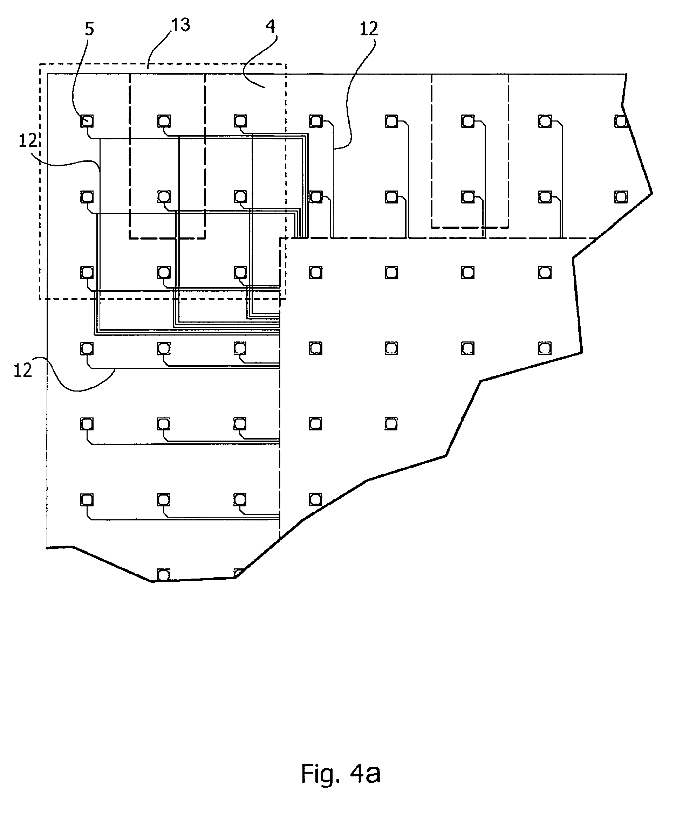

Fig. 4a shows a layout of conductive traces in the cuttable region 10 of the PCB 4 of the embodiment shown on Figs. 2 and 3. A first terminal of each LED 5 located in the cuttable region 10 is connected to a common wire (not shown). In the preferred embodiment a common wire is made as a separate conductive layer located on the back side of the PCB 4. Whereas a second terminal of each LED 5 located in the cuttable region 10 is connected by a conductive trace or printed wire 12 to a corresponding LED driver (not shown) located in the non-cuttable region 11. Further the LEDs 5 located in corner area 13 limited by dotted line are connected to the corresponding LED drivers by redundant conductive traces 12. Preferably two conducive traces connecting LED 5 located in corner area 13 with corresponding driver are located substantially along a rectangle having one corner in a vicinity of the LED 5 and the diagonally opposite corner in the non-cuttable region 11.

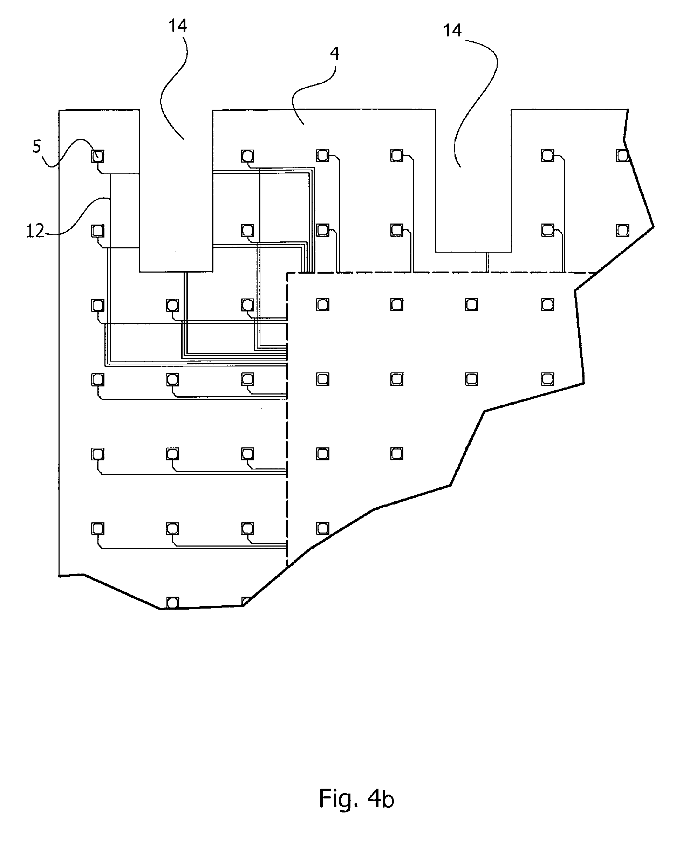

Fig. 4b shows the same panel as shown on Fig. 4a, where two parts 14 of the panel are cut out together with LEDs and conductive traces without detriment to the functionality of the remaining panel.

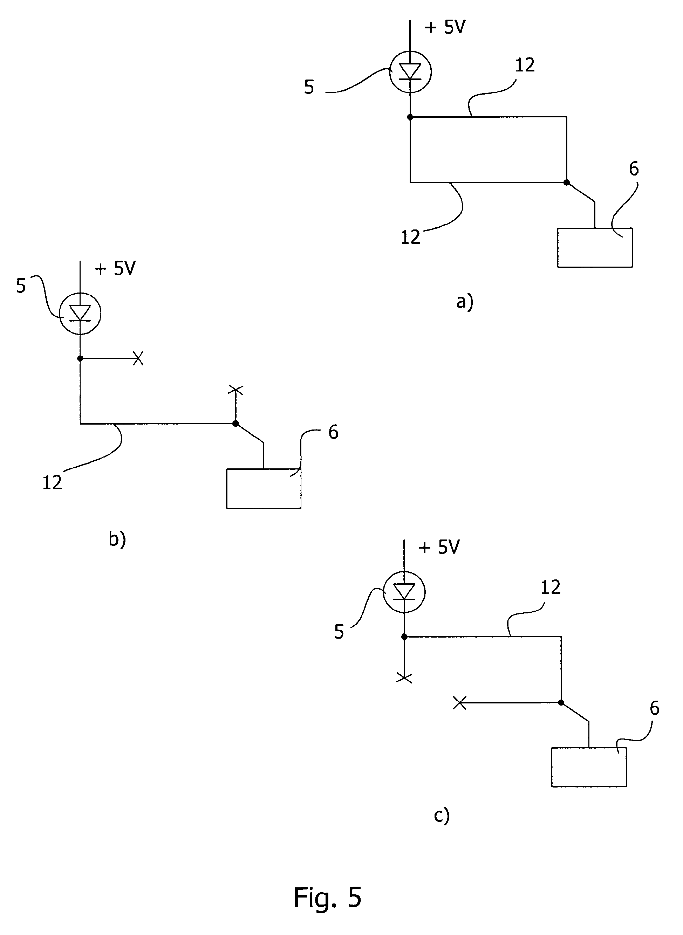

Some details of electrical connection between the LED 5 and LED driver 6 are illustrated in Fig. 5. Here view a) shows that under usual conditions there are two paths between the LED and driver. Each of views b) and c) shows only one connecting path between the LED and driver, while another path is cut out together with other elements to pass over a protruding element on the mounting surface. It is one of essential advantages of the present invention in comparison with the prior art, allowing easy and convenient assembling of a large-area display in architectural installations.

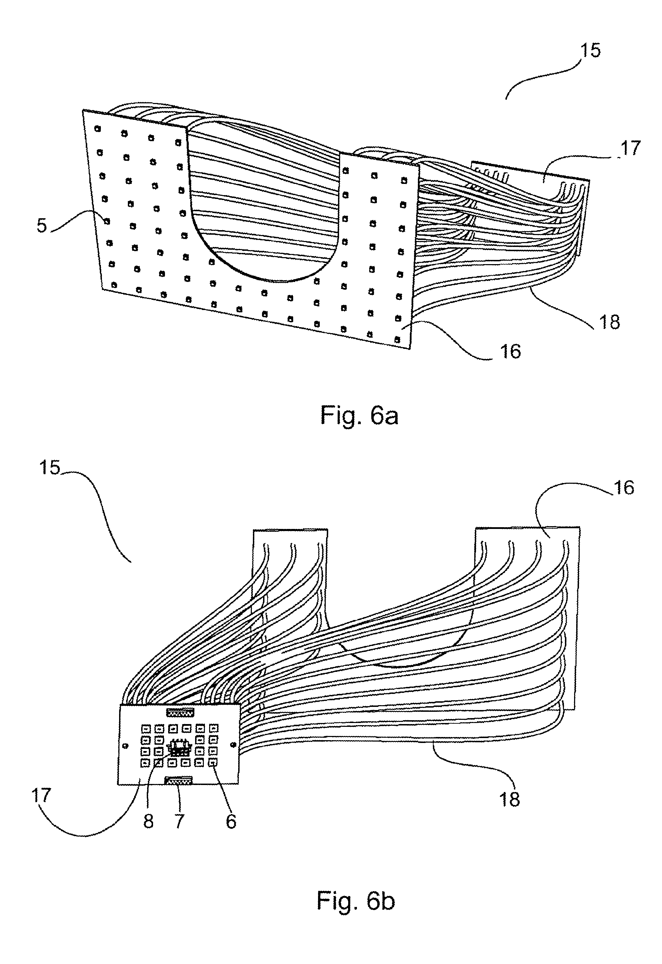

Fig.6a shows a front perspective view and Fig. 6b shows a back perspective view of an alternative embodiment of the display panel in accordance with the present invention. This type of the panel is used in situation where an obstacle or protruding element on the wall is located near the center of the panel or in case of a complex protruding element. A central part of the panel shown on Fig. 6a and 6b is cut out. According to this embodiment, the display panel 15 comprises a PCB 16 with LEDs 5 mounted on its front side and an additional PCB 17 on which LED drivers 6, data connectors 7 and power connector 8 are mounted. The LEDs 5 mounted on PCB 16 are connected with LED drivers 6 mounted on PCB 17 by wires 18. Each LED 5 is connected to corresponding driver 6 by a separate wire. Thus, in this embodiment any part of the PCB 16 can be removed without detriment to the functionality of the remaining panel. So, this alternative approach allows convenient construction of large-area displays on most complicated architectural surfaces.

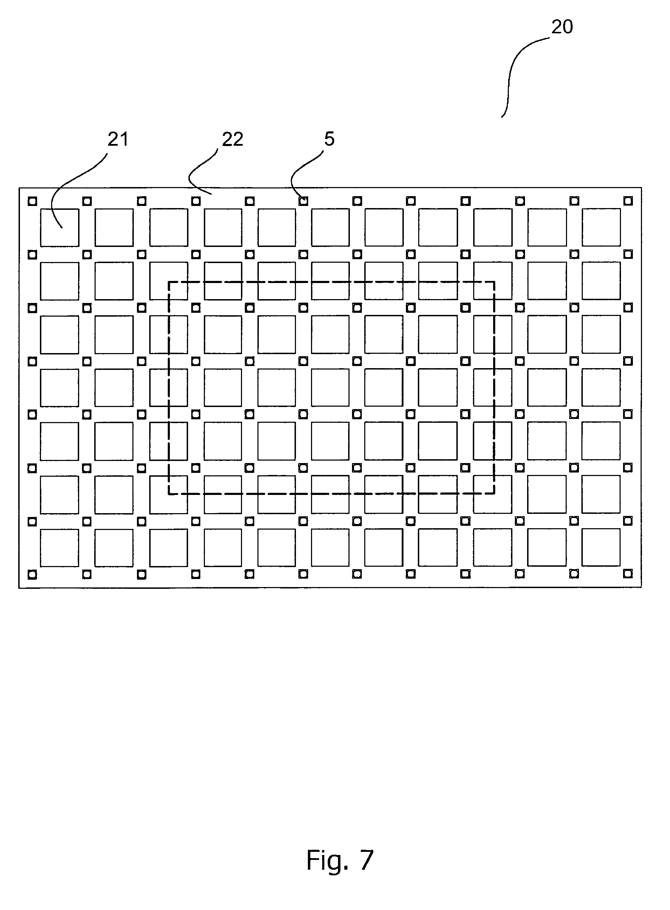

Fig.7 shows still another embodiment of a display panel in accordance with the present invention. The display panel 20 differs from the panel 2 of Figs. 2a and 2b in that it comprises openings 21 in the PCB 22. The openings 21 can be made, for example, by milling method. This type of the display panel is used in a situation when it is necessary to let wind, light or sound to pass through the display system surface.

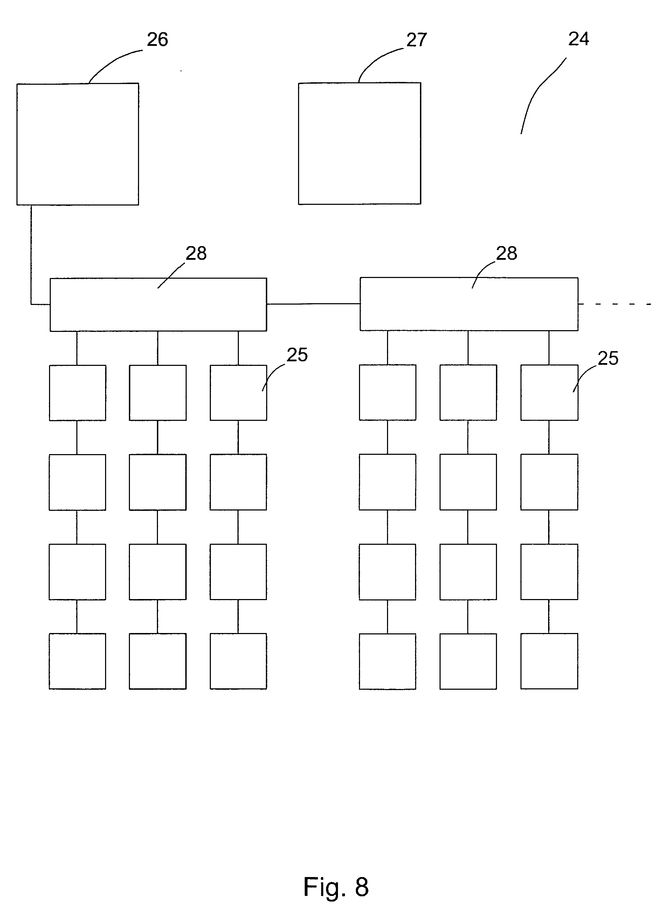

Referring to Fig. 8 a schematic diagram of an embodiment of a large-area display system. The display system 24 is similar to those shown on Fig. 1 but has a larger number of display panels in accordance with one or more embodiments of the present invention. The system 24 includes a data source or a main processor 26, a power source 27 and one or plurality of control units 28 connected to several display panels 25.

Many display systems comprised of multiple panels exist in the art, and thus the construction of the display system 24, and specifically the connection of the display panels 25 therein, is well within the ability of those skilled in the art.

Thus, the present invention provides an effective arrangement of large-area displays on the basis of the offered panels, which are provided with the capability of arbitrary cutting-out according to actual state of large vertical or horizontal mounting surfaces.

Embodiments of the present invention may provide one or more of the following advantages. First, a cuttable display panel is provided which may be easily adapted to fit into an existing architectural structure. Further, a large-area display system is provided which may be easily assembled on existing architectural structure and accommodate existing obstacles on the mounting wall.

Furthermore, it is possible to customize a display panel of present invention on construction site, which allows a fine adjusting of the display system.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. A cuttable display panel, comprising:
a printed circuit board (PCB);
a two-dimensional array of light emitting elements mounted on the PCB;
a control circuitry electrically connected to the light emitting elements for controlling their light emission, **characterized in that**
the panel is adapted for mounting on a wall;
said control circuitry comprises a plurality of light drivers connected to the light emitting elements on one-to-one basis; and that
a part of the panel can be removed, for example by cutting out, to accommodate an obstacle on the wall.

2. The display panel of claim 1, wherein the light emitting element comprises a first terminal and a second terminal, wherein said first terminal is connected to a common wire; and said second terminal is connected to the corresponding light driver.

3. The display panel of claim 1 or 2, wherein said PCB comprises a non-cuttable region and a cuttable region, wherein said light drivers are mounted in the non-cuttable region of said PCB.

4. The display panel of claim 1, 2 or 3, wherein said light emitting element comprises a light emitting diode (LED).

5. The display panel of claim 3 or 4, wherein said cuttable region is located in a peripheral part of said PCB, and the removable part is a marginal part.

6. The display panel of claim 3, or 5, wherein said cuttable region comprises a corner part, wherein a light emitting element located in said corner part is connected to said light driver at least by two printed wires.

7. The display panel of claim 6, wherein said two printed wires connecting said light emitting element to said light driver are located substantially along a rectangle having one corner in a vicinity of said light emitting element and the diagonally opposite corner in the non-cuttable region of said PCB.

8. A large-area display, comprising a plurality of display panels mounted on a wall, wherein each of the display panels comprises:
a printed circuit board (PCB);
a two-dimensional array of light emitting elements mounted on the PCB;
a control circuitry electrically connected to the light emitting elements for controlling their light emission, **characterized in that**
said control circuitry comprises a plurality of light drivers connected to the light emitting elements on one-to-one basis;
said plurality of display panels comprises at least one cuttable panel a part of which is removed to accommodate an obstacle on the wall.

9. A method for assembling a large-area display, comprising the following steps:
providing a plurality of panels, adapted for mounting on a wall wherein said plurality comprises a number of cuttable panels;
providing a wall allowably having an obstacle;
cutting out a part of the cuttable panel to accommodate an obstacle on the wall;
fixing said plurality of panels on the wall;
connecting said plurality of panels to each other and/or to data and power sources.
